# EUROPEAN PATENT SPECIFICATION

(11) **EP 2 083 098 B1**
(45) Date of publication and mention of the grant of the patent: **31.12.2014**
(21) Application number: 09150893.7
(22) Date of filing: 20.01.2009
(51) Int. Cl.: C30B 15/30, C30B 29/06

(54) **Apparatus for manufacturing semiconductor single crystal ingot and method using the same**
Vorrichtung zur Herstellung eines Halbleiter-Einkristall und Verwendungsverfahren dafür
Appareil pour la fabrication d'un monocristal semi-conducteur et son procédé d'utilisation

(30) Priority: 21.01.2008 KR 20080006307
(43) Date of publication of application: 29.07.2009
(73) Proprietor: Siltron Inc., Gumi-city, Gyeonsangbuk-Do 730-724 (KR)
(72) Inventor: Cho, Hyon-Jong, 730-380, Gyeongbuk (KR); Hong, Young-Ho, 137-844, Seoul (KR); Lee, Hong-Woo, 730-020, Gyeongbuk (KR); Kang, Jong-Min, 302-160, Daejeon (KR); Kim, Dae-Yeon, 730-724, Gyeongbuk (KR)
(74) Representative: Habermann, Gert

(56) References cited:
- EP-A- 0 745 706
- EP-A- 1 087 040
- JP-A- 2000 264 771

## Description

### FIELD OF THE INVENTION

The present invention relates to an apparatus for manufacturing a semiconductor single crystal ingot and a method using the same, and in particular to an apparatus for manufacturing a semiconductor single crystal ingot that provides a large and uniform temperature gradient in a radial direction of a solid-liquid interface in the manufacture of the semiconductor single crystal ingot by a Czochralski (hereinafter abbreviated to CZ) method, in particular, increases a temperature gradient of a center area of the solid-liquid interface, and a method using the same.

### BACKGROUND OF THE INVENTION

The CZ method is widely used to manufacture a semiconductor single crystal ingot, and grows a semiconductor single crystal ingot from a silicon melt in a quartz crucible. The CZ method uses a heater installed around a side wall of the quartz crucible to heat the silicon melt, and consequently, a natural convection is generated in the silicon melt. And, the CZ method manufactures a high-quality silicon single crystal free of grown-in defects generated from vacancy or self-interstitial by controlling a rotation rate of the single crystal or the quartz crucible, and consequently a forced convection is also generated in the silicon melt due to the control of rotation rate. It is well known that the natural and forced convection can be controlled by a horizontal magnetic field.

A method for applying a horizontal magnetic field to a silicon melt is referred to as a HMCZ (Horizontal Magnetic field Czochralski) method. A typical HMCZ method forms a magnetic field such that MGP (Maximum Gauss Plane) is located near the surface of a silicon melt. The MGP is a plane where a vertical component of a magnetic field is substantially close to '0', and a flux density of the magnetic field in a horizontal direction becomes maximum. The horizontal magnetic field has characteristics that the vertical component of the magnetic field becomes '0' at a central axis of a silicon single crystal. The HMCZ method using a horizontal magnetic field may suppress a vertical convection in a silicon melt and provides an advantage of easily growing a silicon single crystal.

Meanwhile, interstitial oxygen in a silicon wafer is used in various ways to manufacture a highly integrated semiconductor device. For example, the interstitial oxygen improves a mechanical strength of the silicon wafer to make the silicon wafer resistant against thermal stress generated during the manufacturing process of the device, and precipitates into micro-defects that serve as a gettering site to remove heavy metal impurities during the manufacturing process of the device.

The typical HMCZ method has an advantage of easily growing a single crystal ingot, but induces a change of an interstitial oxygen concentration in axial and radial directions of the ingot, resulting in production yield reduction of the ingot. This is because the locations of a high temperature area and a low temperature area on the surface of a silicon melt are changed due to an asymmetrical convection distribution of the silicon melt, so that an oxygen concentration distribution of a solid-liquid interface is not uniformly maintained. Here, the high temperature area is an area on the surface of the silicon melt having relatively higher temperature, and the low temperature area is an area on the surface of the silicon melt having relatively lower temperature.

To solve the above-mentioned problem, Korean Laid-open Patent Publication No. 2001-34851 discloses a method for manufacturing a silicon single crystal that applies a horizontal magnetic field to a silicon melt such that a vertical/horizontal component ratio of the horizontal magnetic field is 0.3 to 0.5 at the center of a solid-liquid interface to constantly maintain a high temperature area or a low temperature area having a uniform oxygen concentration at the solid-liquid interface, so that uniformity of oxygen concentration is improved in axial and radial directions of the single crystal.

However, since a non-linear forced convection is generated by rotation of a single crystal and a quartz crucible during growth of a silicon single crystal, it is difficult to fix the locations of a high temperature area and a low temperature area on the surface of a silicon melt throughout the single crystal growing process by controlling only a vertical/horizontal component ratio of a horizontal magnetic field. That is, simply controlling a vertical/horizontal component ratio of a horizontal magnetic field can not fundamentally prevent mixing of a high temperature area and a low temperature area or change in locations of the high temperature area and the low temperature area.

And, the Korean Laid-open Patent Publication No. 2001-34851 specifies a method for reducing a deviation of oxygen concentration in an axial or radial direction of a silicon single crystal, but does not mention a method to grow a high-quality silicon single crystal without grown-in crystal defects, at a rapid growing speed.

For example, EP 0 745 706 A1 suggests an apparatus for manufacturing a semiconductor single crystal ingot by means of the horizontal magnetic field Czochralski (HMCZ) method in which a pair of magnetic coils produces a maximum Gauss plane, below the melt level, in the range between 4000 to 6000 Gauss and a weaker magnetic field of about 4000 Gauss to be applied below the solid-liquid interface.

Furthermore, from JP 20026771 A a corresponding method is known, in which the non-lateral magnetic field components do not exceed 1500 Gauss.

### SUMMARY OF THE INVENTION

The present invention is designed to solve the above-mentioned problems. Therefore, it is an object of the present invention to provide an apparatus that controls distribution and density of a horizontal magnetic field to manufacture a high-quality semiconductor single crystal, and a method using the same.

It is another object of the present invention to provide an apparatus that controls distribution and density of a horizontal magnetic field to maximize the heat flow toward a solid-liquid interface from a heater, so that a temperature gradient of a center portion of the solid-liquid interface is increased to improve a pulling speed of a defect-free single crystal, and a method using the same.

It is yet another object of the present invention to provide an apparatus that controls distribution and density of a horizontal magnetic field to expand a processing margin of a defect-free pulling speed.

In order to achieve the objects of the present invention, the present invention provides an apparatus for manufacturing a semiconductor single crystal ingot according to claim 1, a quartz crucible for receiving a semiconductor melt; a heater installed around a side wall of the quartz crucible; a single crystal pulling means for pulling a single crystal from the semiconductor melt received in the quartz crucible; and a magnetic field applying means comprising a coil pair installed at opposite sides around the quartz crucible such that the coil pair forms a Maximum Gauss Plane at a location of ML-100 mm to ML-350 mm based on a Melt Level of the melt surface, and applies a strong magnetic field of 3000 to 5500 Gauss to an intersection between the MGP and the side wall of the quartz crucible and a weak magnetic field of 1500 to 3000 Gauss below a solid-liquid interface, each coil pair has a ring shape with a flat upper part.

In order to achieve the objects of the present invention, the present invention provides a method for manufacturing a semiconductor single crystal ingot that pulls a semiconductor single crystal from a semiconductor melt received in a quartz crucible by a Czochralski process according to claim 5, comprising applying a horizontal magnetic field to the semiconductor melt during growth of the semiconductor single crystal ingot by forming a Maximum Gauss Plane at a location of ML-1 00 mm to ML-350 mm based on a Melt Level of the melt surface, and applying a strong magnetic field of 3000 to 5500 Gauss to an intersection between the MGP and a side wall of the quartz crucible and a weak magnetic field of 1500 to 3000 Gauss below a solid-liquid interface.

The direction of current applied to each coil of the magnetic field applying means is determined by an electromagnetic law to meet the above-mentioned magnetic field forming conditions.

The horizontal magnetic field may be formed by controlling radius, location or shape of each coil of the magnetic field applying means, or direction and magnitude of current applied to the each coil.

The MGP intersection is approximately consistent with a side wall area of the quartz crucible heated to a highest temperature by heat emitted from a heater. Accordingly, in case that a strong magnetic field is formed at the MGP intersection, an amount of heat flux provided below the solid-liquid interface is increased. And, in case that a weak magnetic field is formed below the solid-liquid interface, the heat flux provided by the heater is effectively transferred to the solid-liquid interface to increase a temperature gradient of the solid-liquid interface, in particular a temperature gradient of a center portion of the solid-liquid interface.

### BRIEF DESCRIPTION OF THE DRAWING

The present invention will be more fully described in the following detailed description, taken accompanying drawings, however, the description proposed herein is just a preferable example for the purpose of illustrations, not intended to limit the scope of the invention.
FIG. 1 is a cross-sectional view illustrating schematically an apparatus for manufacturing a semiconductor single crystal ingot according to an embodiment of the present invention.
FIGs. 2a and 2b are views illustrating coil arrangement structures of a magnetic field applying means.
FIG. 3 is a view illustrating distribution and direction of a horizontal magnetic field formed according to comparative examples 1 and 2.
FIG. 4 is a view illustrating distribution and direction of a horizontal magnetic field formed according to example 1.
FIG. 5 is a view illustrating distribution and direction of a horizontal magnetic field formed according to example 3.
FIG. 6 is a view illustrating a defect distribution according to change in a pulling speed and a defect-free pulling speed per area, obtained through a vertical sampling inspection of an ingot grown according to comparative example 1.
FIG. 7 is a view illustrating a defect distribution according to change in a pulling speed and a defect-free pulling speed per area, obtained through a vertical sampling inspection of an ingot grown according to comparative example 2.

### DETAILED DESCRIPTION OF THE INVENTION

Hereinafter, preferred embodiments of the present invention will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present invention on the basis of the principle that the inventor is allowed to define terms appropriately for the best explanation. Therefore, the description proposed herein is just a preferable example for the purpose of illustrations only, not intended to limit the scope of the invention, so it should be understood that other equivalents and modifications could be made thereto without departing from the spirit and scope of the invention.

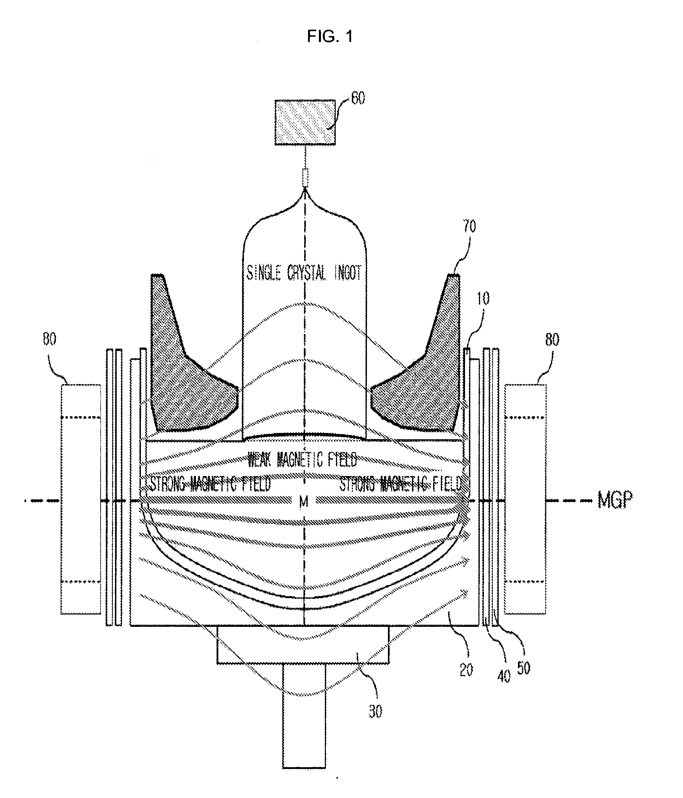

FIG. 1 is a cross-sectional view illustrating schematically an apparatus for manufacturing a semiconductor single crystal according to an embodiment of the present invention.

Referring to FIG. 1, the apparatus includes a quartz crucible 10 for receiving a semiconductor melt (M) melted at a high temperature, a crucible housing 20 surrounding an outer periphery of the quartz crucible 10 for supporting the quartz crucible 10 for a uniform shape, a crucible rotating means 30 installed below the crucible housing 20 for rotating the crucible housing 20 and the quartz crucible 10, a heater 40 spaced a predetermined distance from a side wall of the crucible housing 20 for heating the quartz crucible 10, an insulating means 50 installed around the heater 40 for preventing an outward leakage of heat emitted from the heater 40, a single crystal pulling means 60 for pulling a single crystal ingot from the semiconductor melt (M) received in the quartz crucible 10 using a seed crystal, and a heat shield means 70 spaced a predetermined distance from an outer periphery of the single crystal ingot pulled by the single crystal pulling means 60 for shielding heat emitted from the single crystal ingot.

The above-mentioned components are typical components of a well-known apparatus for manufacturing a semiconductor single crystal by a CZ method, and the detailed description of each component is omitted. The semiconductor melt (M) may be a silicon melt obtained by melting a polycrystalline silicon, however the present invention is not limited to a specific kind of semiconductor melt. Therefore, the present invention can be applied to any semiconductor single crystal that is known to grow by a CZ method.

The apparatus for manufacturing a semiconductor single crystal ingot according to the present invention further includes a magnetic field applying means 80 for applying a horizontal magnetic field. Here, the horizontal magnetic field is a magnetic field, of which a vertical component of a magnetic field passing through a central axis of a single crystal ingot is substantially '0'.

In FIG. 1, the distribution and direction of the horizontal magnetic field are indicated by lines and rows. The higher the density of lines of the magnetic field, the larger the intensity of the magnetic field. And, the horizontal magnetic field has a Maximum Gauss Plane (MGP). The MGP is a plane, that is, a collection of points having a vertical component of a magnetic field that is substantially '0', and a maximum density of lines of magnetic field in the horizontal direction.

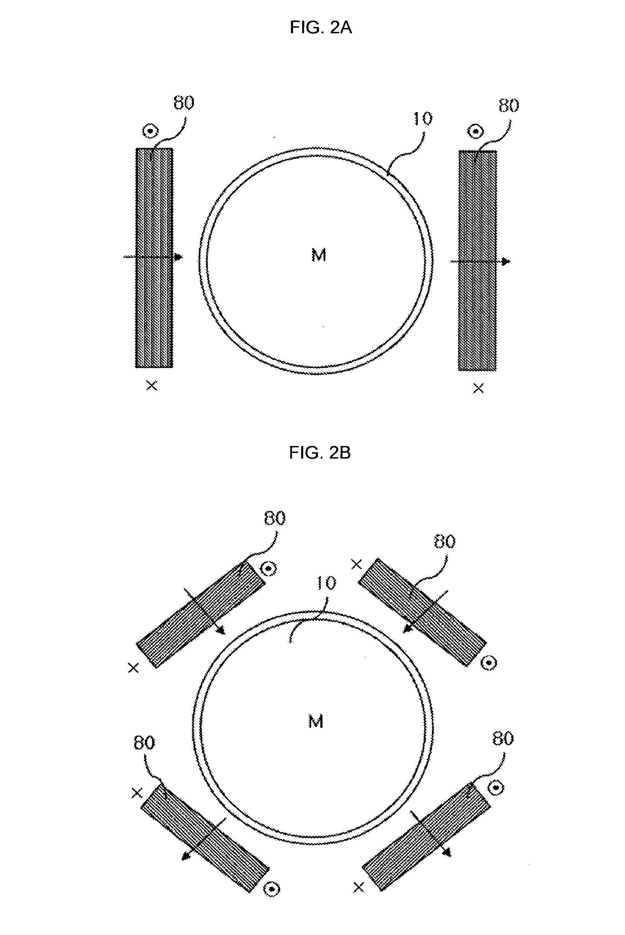

The magnetic field applying means 80 has 2n coils (n is an integer larger than 0) that are arranged symmetrically relative to the quartz crucible 10. The coil has an approximate ring shape, and a normal direction of a plane of the coil is arranged perpendicularly to an outer wall of the insulating means 50. For example, as shown in FIG. 2a, the magnetic field applying means 80 may have two coils that are arranged symmetrically opposite each other around the quartz crucible 10. As shown in FIG. 2b, the magnetic field applying means 80 may have four coils that are arranged symmetrically opposite each other around the quartz crucible 10. The direction of current applied to each coil of FIGs. 2a and 2b is determined such that a magnetic field at a coil center is formed in a direction of an arrow. In FIGs. 2a and 2b, the direction of current is indicated by marks of 'x' and '⊙'. The mark 'x' represents a direction of current flowing into ground, and the mark '⊙' represents a direction of current flowing out the ground.

Preferably, the magnetic field applying means 80 forms a weak magnetic field below the solid-liquid interface where a semiconductor single crystal is grown, and a strong magnetic field at an intersection (hereinafter referred to as an 'MGP intersection') between the MGP and the side wall of the quartz crucible 10. Here, the weak magnetic field is formed directly below the solid-liquid interface. And, the weak magnetic field is a magnetic field having an intensity of about 1500 to 3000 Gauss, and the strong magnetic field is a magnetic field having an intensity of about 3000 to 5500 Gauss. The intensity conditions of the magnetic field are selected for the purpose of increasing a temperature gradient of a center portion of the solid-liquid interface. Here, unless otherwise specified, the temperature gradient is a vertical temperature gradient of the solid-liquid interface in the direction of single crystal. Meanwhile, preferably the MGP is located at ML-100 mm to ML-350 mm based on ML (Melt Level) that is a height of the melt surface measured at the center of the solid-liquid interface. The location conditions of the MGP are selected for the purpose of increasing an amount of heat flux provided from the heater 40 to the solid-liquid interface to the maximum extent. The location of the MGP is approximately consistent with an area of the side wall of the quartz crucible 10 where a largest temperature increase occurs due to heat emitted from the heater 40. In a high temperature silicon melt region near the side wall of the quartz crucible 10 heated by the heater 40, a natural convection is suppressed by the strong magnetic field and the flow of the high temperature silicon melt is promoted along the lines of horizontal magnetic force, so that heat is effectively transferred below the solid-liquid interface. The heat transferred below the solid-liquid interface can be actively transmitted vertically to the solid-liquid interface in the weak magnetic field area.

The horizontal magnetic field may be formed by controlling location of each coil, direction of current applied to the each coil or intensity of a magnetic field generated from the each coil. Alternatively, weak and strong magnetic fields may be formed below the solid-liquid interface and at the MGP intersection, respectively, by controlling radius of each coil. That is, as the radius of the coil is reduced, the magnetic field of the MGP intersection becomes stronger and the magnetic field below the solid-liquid interface becomes weaker. Further alternatively, weak and strong magnetic fields may be formed below the solid-liquid interface and at the MGP intersection, respectively, by changing the shape of a ring-shaped coil. For example, as the shape of the coil is changed by reducing a curvature of an upper part of the coil rather than a lower part of the coil, the magnetic field of the MGP intersection becomes stronger and the magnetic field below the solid-liquid interface becomes weaker. Still further alternatively, weak and strong magnetic fields may be formed below the solid-liquid interface and at the MGP intersection, respectively, by shielding a magnetic field generated from an upper part of the coil. It is obvious to ordinary persons skilled in the art that the above-mentioned methods for forming a magnetic field may be used in combination or singularly.

When the horizontal magnetic field is applied to the semiconductor melt (M) according to the present invention, an amount of heat flux flowing from the heater 40 to the solid-liquid interface is increased. Because a strong magnetic field is formed at the MGP intersection, convection of the semiconductor melt (M) is suppressed in an area of the quartz crucible 10 having a highest temperature, and consequently an amount of heat transmitted below the solid-liquid interface is increased. And, because a weak magnetic field is formed below the solid-liquid interface, heat transmitted from the heater 40 by the heat flux is actively transmitted to the solid-liquid interface. As a result, a temperature gradient of the solid-liquid interface, in particular a temperature gradient of a center portion of the solid-liquid interface is increased, thereby improving a pulling speed of a defect-free single crystal.

Meanwhile, according to the Voronkov's theory related to growth of a semiconductor single crystal, a processing margin of a pulling speed for growing a defect-free semiconductor single crystal ingot is closely related with a deviation of temperature gradient of the solid-liquid interface in a radial direction. That is, as a deviation of temperature gradient between a center portion of the solid-liquid interface and an edge portion of the solid-liquid interface becomes smaller, a processing margin of a pulling speed is increased. The present invention can increase a temperature gradient of a center portion of a solid-liquid interface that is difficult to control, by use of a horizontal magnetic field, and therefore, controls a temperature of an edge portion of the solid-liquid interface by controlling a melt-gap, which is a gap between the heat shield means 70 and the semiconductor melt (M), to reduce a deviation of temperature gradient of the solid-liquid interface in a radial direction, thereby easily expanding a processing margin of a pulling speed.

Hereinafter, a method for manufacturing a silicon single crystal ingot using the apparatus according to the present invention is described.

First, polycrystalline silicon is charged into the quartz crucible 10 in accordance with desired conditions of a silicon single crystal ingot to be manufactured. Next, the heater 40 is operated to melt the polycrystalline silicon. After the polycrystalline silicon is melted, the quartz crucible 10 is rotated in a predetermined direction by the crucible rotating means 30. After a predetermined time passes, convection of the silicon melt (M) is stabilized, and then the single crystal pulling means 60 is controlled to dip a seed crystal into the silicon melt (M) and pull up the seed crystal while slowly rotating the seed crystal. In this way, a silicon single crystal ingot is grown. At an early stage of growth, a pulling speed of the seed crystal is controlled such that diameter of the single crystal is increased to a desired diameter and thus a shoulder of the ingot is formed. After the shoulder is formed, a body of the ingot is grown at a defect-free pulling speed while maintaining the diameter of the body. After the body is grown, the pulling speed is increased such that a lower end of the ingot comes out of the silicon melt (M) while slowly reducing the diameter of the ingot. Thereby, growth of the ingot is completed.

During growth of the ingot, a horizontal magnetic field is applied to the silicon melt (M) by the magnetic field applying means 80. The horizontal magnetic field forms a weak magnetic field below the solid-liquid interface and a strong magnetic field at the MGP intersection. Applying the horizontal magnetic field according to the above-mentioned conditions increases an amount of heat flux from the heater 40 toward the solid-liquid interface, thereby increasing a temperature gradient of the solid-liquid interface, in particular a temperature gradient of a center portion of the solid-liquid interface. And, while the horizontal magnetic field is applied, the melt-gap between the heat shield means 70 and the silicon melt (M) is controlled to increase a temperature gradient of an edge portion of the solid-liquid interface, thereby removing a deviation in temperature gradient between a center portion of the solid-liquid interface and the edge portion of the solid-liquid interface. Applying the horizontal magnetic field and controlling the melt-gap according to the invention, the temperature gradient of the solid-liquid interface is increased on an overall area of the solid-liquid interface to improve a defect-free pulling speed, and the deviation in temperature gradient between the center portion and the edge portion of the solid-liquid interface is reduced to expand a processing margin of a defect-free pulling speed.

### <Experimental examples>

Hereinafter, the present invention is described in more detail through experimental examples. It should be interpreted that the experimental examples are given to help understand the present invention and the present invention is not limited to terms or conditions of the experimental examples.

### Comparative example 1

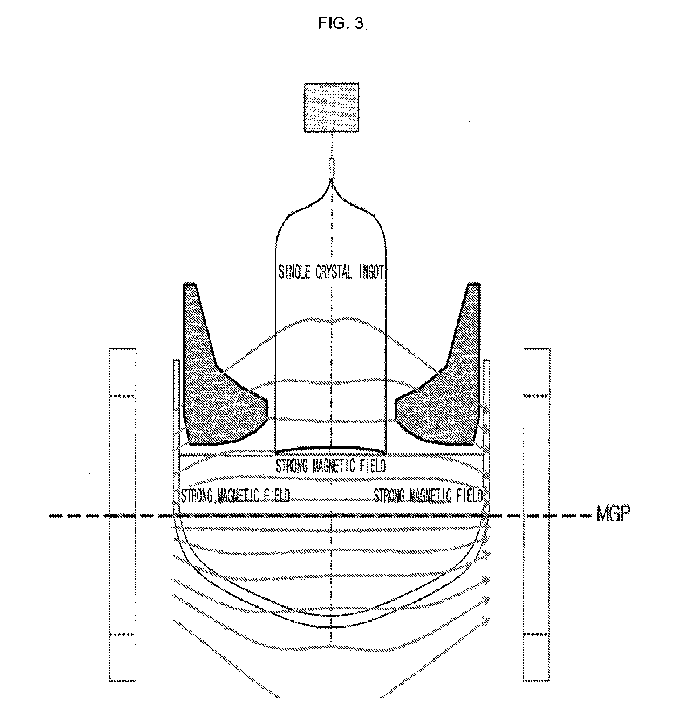

A silicon single crystal ingot was grown by optimizing a hot zone and setting a melt-gap to 50 mm so that a defect-free pulling speed margin is obtained between an upper pulling speed and a lower pulling speed while changing a pulling speed. The pulling speed was gradually reduced from an early stage of growth to a later stage. During growth of the ingot, a horizontal magnetic field was applied to form a magnetic field of 3300 Gauss below a solid-liquid interface and a magnetic field of 4000 Gauss at an MGP intersection. The horizontal magnetic field was formed by arranging two coils as shown in FIG. 2a. FIG. 3 shows the distribution and direction of the magnetic field formed according to comparative example 1. It is found through FIG. 3 that a strong magnetic field having a high intensity of magnetic field was formed below the solid-liquid interface as well as at an MGP intersection.

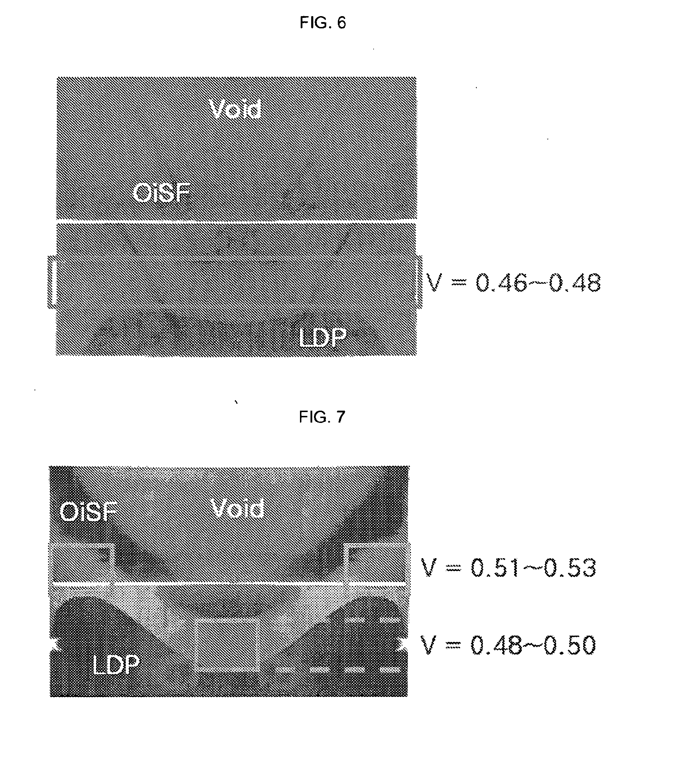

After the ingot was grown, the ingot was cut in an axial direction and evaluated through a vertical sampling inspection. FIG. 6 shows a defect distribution according to change in pulling speed and a defect-free pulling speed per area, obtained through the vertical sampling inspection. In FIG. 6, a void is a crystal defect caused by a vacancy, OiSF (Oxidation induced Stacking Fault) is an area where a stacking fault is generated by thermal oxidation, and LDP (Large Dislocation Pit) is a crystal defect generated by interstitial agglomerates. Referring to FIG. 6, it is found that each defect-free pulling speed of a center portion and an edge portion of the ingot is 0.47 mm/min and a processing margin of a defect-free pulling speed is 0.02 mm/min.

### Comparative example 2

A silicon single crystal ingot was grown under the same conditions as the comparative example 1 except that a melt-gap was set to 40mm, and gone through a vertical sampling inspection. FIG. 7 shows a defect distribution according to changing pulling speed and a defect-free pulling speed per area, obtained through the vertical sampling inspection. Referring to FIG. 7, it is found that a defect-free pulling speed of a center portion of the ingot is 0.49 mm/min, a defect-free pulling speed of an edge portion of the ingot is 0.52 mm/min, and a processing margin of a defect-free pulling speed is not obtained.

### Example 1

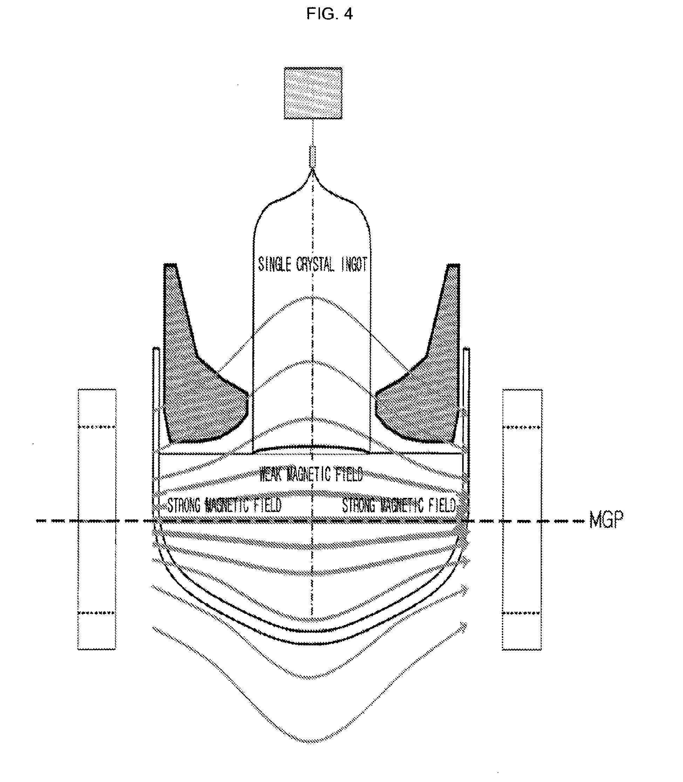

A radius of the coil used in the comparative example was reduced to 70%, and a melt-gap was set to 40 mm. FIG. 4 shows the distribution and direction of the horizontal magnetic field formed by coils used in example 1. It is found that as the radius of the coil is reduced, a strong magnetic field having a high intensity of magnetic field is formed at an MGP intersection located adjacent to the coil and a weak magnetic field having a low intensity of magnetic field is formed below a solid-liquid interface located far from the coil. The magnetic field formed below the solid-liquid interface has magnitude of 2300 Gauss and the magnetic field formed at the MGP intersection has magnitude of 3700 Gauss. According to results (not shown) of a vertical sampling inspection of a silicon single crystal ingot manufactured according to example 1, it is found that each defect-free pulling speed of a center portion and an edge portion of the ingot is 0.53 mm/min, and a processing margin of a defect-free pulling speed is 0.025 mm/min.

### Example 2

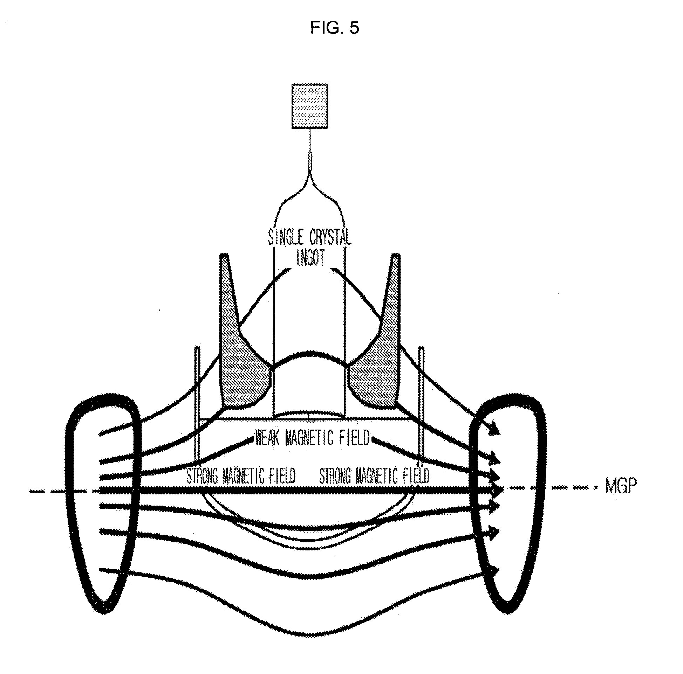

A horizontal magnetic field was formed by arranging two coils as shown in FIG. 2a, with each coil having a flat upper part, and a melt-gap was set to 38 mm. FIG. 5 shows the distribution and direction of magnetic field of the horizontal magnetic field formed according to example 2. The density of lines of magnetic field increases at a central axis of the coil and a lower part of the coil, and accordingly a strong magnetic field is formed at an MGP intersection. On the contrary, the density of lines of magnetic field below a solid-liquid interface reduces, and accordingly a weak magnetic field is formed below the solid-liquid interface. Applying the horizontal magnetic field, a weak magnetic field of 2400 Gauss is formed below the solid-liquid interface and a strong magnetic field of 3250 Gauss is formed at the MGP intersection. According to results (not shown) of a vertical sampling inspection of a silicon single crystal ingot manufactured according to example 2, it is found that each defect-free pulling speed of a center portion and an edge portion of the ingot is 0.545 mm/min, and a processing margin of a defect-free pulling speed is 0.025 mm/min.

### Example 3

A horizontal magnetic field was formed by arranging four coils as shown in FIG. 2b, and a melt-gap was set to the same level as example 1. Applying the horizontal magnetic field, a weak magnetic field of 2500 Gauss is formed below a solid-liquid interface and a strong magnetic field of 3500 Gauss is formed at an MGP intersection. According to results (not shown) of a vertical sampling inspection of a silicon single crystal ingot manufactured according to example 3, it is found that a defect-free pulling speed of a center portion of the ingot is 0.535 mm/min, a defect-free pulling speed of an edge portion of the ingot is 0.530 mm/min, and a processing margin of a defect-free pulling speed is 0.023 mm/min.

The following table shows the measurement results obtained from comparative examples 1 and 2 and examples 1 to 3.

**<Table 1>**

| | Melt-Gap (mm) | Intensity of magnetic field (relatively strong/intermediate/weak) | | | Center portion V* (mm/min.) | Edge portion V* (mm/min.) | ΔV (mm/min.) |
|---|---|---|---|---|---|---|---|
| | | Below a solid-liquid interface | MGP intersection | Bottom of a crucible | | | |
| Comparative example 1 | 50 | strong | strong | strong | 0.47 | 0.47 | 0.02 |
| Comparative example 2 | 40 | strong | strong | strong | 0.49 | 0.52 | not obtained |
| Example 1 | 40 | weak | strong | intermediate | 0.53 | 0.53 | 0.025 |
| Example 2 | 38 | weak | strong | strong | 0.545 | 0.545 | 0.025 |
| Example 3 | 40 | weak | strong | weak | 0.535 | 0.530 | 0.023 |

Referring to Table 1, it is found that in single crystal growth by a CZ method, a horizontal magnetic field is applied to form a weak magnetic field below a solid-liquid interface and a strong magnetic field at an MGP intersection, thereby increasing a pulling speed of a defect-free single crystal and expanding a processing margin of a defect-free pulling speed.

According to an aspect of the present invention, the present invention effectively transmits heat emitted from the heater toward a region below the solid-liquid interface where a single crystal is grown, thereby improving a pulling speed of a defect-free single crystal. Consequently, the present invention can improve productivity of a defect-free single crystal ingot.

According to another aspect of the present invention, the present invention improves a temperature gradient of the solid-liquid interface, and at the same time, controls a melt-gap capable of controlling a temperature gradient of an edge portion of a single crystal, thereby expanding a processing margin of a defect-free pulling speed.

According to yet another aspect of the present invention, the present invention actively transmits heat emitted from the heater toward a region below the solid-liquid interface, where a single crystal is grown, thereby reducing a heating power of the heater, resulting in reduction of energy needed to operate the heater.

Hereinabove, preferred embodiments of the present invention has been described in detail with reference to the accompanying drawings. However, it should be understood that the detailed description and specific examples, while indicating preferred embodiments of the invention, are given by way of illustration only, since various changes and modifications will become apparent to those skilled in the art from this detailed description.

## Claims

1. An apparatus for manufacturing a semiconductor single crystal ingot, comprising:
a quartz crucible (10) for receiving a semiconductor melt (M);
a heater (40) installed around a side wall of the quartz crucible (10);
a single crystal pulling means (60) for pulling a single crystal from the semiconductor melt (M) received in the quartz crucible (10); and
a magnetic field applying means (80) comprising a coil pair installed opposite sides around the quartz crucible (10) **characterised in that** the coil pair forms a Maximum Gauss Plane (MGP) at a location of ML-1 00 mm to ML-350 mm based on a Melt Level (ML) of the melt surface, and applies a strong magnetic field of 3000 to 5500 Gauss to an intersection between the MGP and the side wall of the quartz crucible (10) and a weak magnetic field of 1500 to 3000 Gauss below a solid-liquid interface,
each coil pair has a ring shape with a flat upper part.

2. The apparatus for manufacturing a semiconductor single crystal ingot according to claim 1,
wherein the magnetic field applying means (80) includes a plurality of coil pairs installed at opposite sides around the quartz crucible (10).

3. The apparatus for manufacturing a semiconductor single crystal ingot according to claim 1 or 2,
wherein the magnetic field applying means (80) forms the horizontal magnetic field by controlling size or location of each coil of the coil pair, or direction and magnitude of current applied to the coil.

4. The apparatus for manufacturing a semiconductor single crystal ingot according to claim 1,
wherein the magnetic field applying means (80) forms the MGP intersection so as to be consistent with a location of the quartz crucible (10) heated to a highest temperature by heat emitted from the heater (40).

5. A method for manufacturing a semiconductor single crystal ingot that pulls a semiconductor single crystal from a semiconductor melt received in a quartz crucible by a Czochralski process, comprising:
applying a horizontal magnetic field to the semiconductor melt (M) during growth of the semiconductor single crystal ingot by forming a Maximum Gauss Plane (MGP) at a location of ML-1 00 mm to ML-350 mm based on a Melt Level (ML) of the melt surface, and applying a strong magnetic field of 3000 to 5500 Gauss to an intersection between the MGP and a side wall of the quartz crucible (10) and a weak magnetic field of 1500 to 3000 Gauss below a solid-liquid interface.

6. The method for manufacturing a semiconductor single crystal ingot according to claim 5,
wherein the method further comprises providing a heat shield means (70) around a growing semiconductor single ingot to shield heat emitted from an edge portion of the solid-liquid interface, and controlling a gap between the heat shield means (70) and the semiconductor melt (M) to control a temperature gradient of the edge portion of the solid-liquid interface.

7. The method for manufacturing a semiconductor single crystal ingot according to claim 6,
wherein the temperature gradient of the edge portion of the solid-liquid interface is controlled to the same level as that of a center portion of the solid-liquid interface.

8. The method for manufacturing a semiconductor single crystal ingot according to claim 5,
wherein the horizontal magnetic field is formed by arranging a coil pair at opposite sides around the quartz crucible (10), and
wherein the horizontal magnetic field is formed by controlling size, location or shape of each coil of the coil pair, or direction and magnitude of current applied to the coil.

## Patentansprüche

1. Vorrichtung zur Herstellung eines Halbleiter-Einkristalls, aufweisend:
ein Schmelztiegel (10) zur Aufnahme einer Halbleiter-Schmelze (M);
eine Heizvorrichtung (40), die um eine Seitenwand des Schmelztiegels (10) angeordnet ist;
eine Einkristall-Zugvorrichtung (60) zum Ziehen eines Einkristalls von der Halbleiter-Schmelze (M), die in dem Schmelztiegel (10) aufgenommen ist; und
ein Magnetfeld-Anwendungsmittel (80) aufweisend ein Spulenpaar, das an gegenüberliegenden Seiten um den Schmelztiegel (10) angeordnet ist, **dadurch gekennzeichnet, dass** das Spulenpaar eine Maximum-Gauß-Ebene (MGP) in einer Position bei ML-100mm bis ML-350mm basierend auf einer Schmelzebene (ML) der Schmelzoberfläche ausbildet und ein starkes Magnetfeld von 3000 bis 5500 Gauß bei einer Schnittstelle zwischen der MGP und der Seitenwand des Schmelztiegels (10) und ein schwaches Magnetfeld von 1500 bis 3000 Gauß unterhalb eines Fest-Flüssig-Übergangs anwendet,
wobei jedes Spulenpaar eine Ringform mit einem flachen oberen Abschnitt aufweist.

2. Vorrichtung zur Herstellung eines Halbleiter-Einkristalls nach Anspruch 1, bei welcher das Magnetfeld-Anwendungsmittel (80) eine Vielzahl von Spulenpaaren aufweist, die an gegenüberliegenden Seiten um den Schmelztiegel (10) angeordnet sind.

3. Vorrichtung zur Herstellung eines Halbleiter-Einkristalls nach Anspruch 1 oder 2,
bei welcher das Magnetfeld-Anwendungsmittel (80) ein horizontales Magnetfeld ausbildet, indem die Größe oder Position jeder Spule des Spulenpaars oder die Richtung und die Größenordnung des in die Spule eingeleiteten Stroms gesteuert wird.

4. Vorrichtung zur Herstellung eines Halbleiter-Einkristalls nach Anspruch 1, bei welcher das Magnetfeld-Anwendungsmittel (80) eine MGP-Schnittstelle derart ausbildet, dass diese mit einer Position des Schmelztiegels (10), der mit von der Heizvorrichtung (40) ausgestrahlter Hitze auf eine höchste Temperatur aufgeheizt ist, übereinstimmt.

5. Verfahren zur Herstellung eines Halbleiter-Einkristalls, bei welcher ein Halbleiter-Einkristall aus einer Halbleiter-Schmelze, die in einem Schmelztiegel aufgenommen ist, mittels eines Czochralski-Verfahrens gezogen wird, aufweisend:
- Anwenden eines horizontalen Magnetfelds auf die Halbleiterschmelze (M) während eines Wachsens des Halbleiter-Einkristalls, indem eine Maximum-Gauß-Ebene (MGP) bei einer Position von ML-100mm bis ML-350mm basierend auf einer Schmelzebene (ML) der Schmelzoberfläche ausgeformt wird, und
- Anwenden eines starken Magnetfelds von 3000 bis 3500 Gauß bei einer Schnittstelle zwischen der MGP und einer Seitenwand des Schmelztiegels (10) und ein schwaches Magnetfeld von 1500 bis 3500 Gauß unterhalb eines Fest-Flüssig-Übergangs.

6. Verfahren zur Herstellung eines Halbleiter-Einkristalls nach Anspruch 5, bei welchem das Verfahren weiter aufweist:
- Bereitstellen eines Mittels (70) zur Abschirmung von Hitze um einen wachsenden Halbleiter-Einkristall, um Hitze, die von einem Randabschnitt des Fest-Flüssig-Übergangs ausgestrahlt wird, abzuschirmen und um einen Spalt zwischen dem Mittel (70) zur Abschirmung von Hitze und der Halbleiterschmelze (M) zu steuern, um einen Temperaturgradienten des Randabschnitts des Fest-Flüssig-Übergangs zu kontrollieren.

7. Verfahren zur Herstellung eines Halbleiter-Einkristalls nach Anspruch 6, bei welchem der Temperaturgradient des Randabschnitts des Fest-Flüssig-Übergangs auf den gleichen Wert gesteuert wird, wie derjenige eines mittigen Abschnitts des Fest-Flüssig-Übergangs

8. Verfahren zur Herstellung eines Halbleiter-Einkristalls nach Anspruch 5, bei welchem das horizontale Magnetfeld dadurch ausgeformt wird, dass ein Spulenpaar an gegenüberliegenden Seiten um den Schmelztiegel (10) angeordnet wird, und
bei welchem das horizontale Magnetfeld ausgeformt wird, indem die Größe, Position oder Form jeder Spule des Spulenpaars, oder die Richtung und Größenordnung des in die Spule eingeleiteten Stroms kontrolliert wird.

## Revendications

1. Appareil pour la fabrication d'un lingot monocristallin semi-conducteur, comprenant :
un creuset en quartz (10) destiné à recevoir un bain de fusion de semi-conducteur (M),
un dispositif de chauffage (40) installé autour d'une paroi latérale du creuset en quartz (10),
un moyen de tirage de monocristal (60) destiné à tirer le monocristal à partir du bain de fusion de semi-conducteur (M) reçu dans le creuset en quartz (10), et
un moyen d'application de champ magnétique (80) comprenant une paire de bobines installées à des côtés opposés autour du creuset en quartz (10) **caractérisé en ce que** la paire de bobines forme un plan de Gauss maximal (MGP) à une position de ML-100 mm à ML-350 mm sur la base d'un niveau de bain de fusion (ML) de la surface de bain de fusion, et applique un fort champ magnétique de 3000 à 5500 Gauss à une intersection entre le plan MGP et la paroi latérale du creuset en quartz (10) et un faible champ magnétique de 1500 à 3000 Gauss en dessous d'une interface solide-liquide,
chaque paire de bobines a une forme d'anneau avec une partie supérieure plate.

2. Appareil pour la fabrication d'un lingot monocristallin semi-conducteur selon la revendication 1,
dans lequel le moyen d'application de champ magnétique (80) inclut une pluralité de paires de bobines installées à des côtés opposés autour du creuset en quartz (10).

3. Appareil pour la fabrication d'un lingot monocristallin semi-conducteur selon la revendication 1 ou 2,
dans lequel le moyen d'application de champ magnétique (80) forme le champ magnétique horizontal en commandant la dimension ou la position de chaque bobine de la paire de bobines, ou la direction et l'intensité du courant appliqué à la bobine.

4. Appareil pour la fabrication d'un lingot monocristallin semi-conducteur selon la revendication 1,
dans lequel le moyen d'application de champ magnétique (80) forme l'intersection avec le plan MGP pour qu'elle soit cohérente avec une position du creuset en quartz (10) chauffé à la température la plus élevée par la chaleur émise par le dispositif de chauffage (40).

5. Procédé de fabrication d'un lingot monocristallin semi-conducteur qui tire un monocristal semi-conducteur à partir d'un bain de fusion de semi-conducteur reçu dans un creuset en quartz par un procédé Czochralski, comprenant :
l'application d'un champ magnétique horizontal au bain de fusion de semi-conducteur (M) au cours de la croissance du monocristal semi-conducteur en formant un plan de Gauss maximal (MGP) à une position de ML-100 mm à ML-350 mm sur la base d'un niveau de bain de fusion (ML) de la surface de bain de fusion, et l'application d'un fort champ magnétique de 3000 à 5500 Gauss à une intersection entre le plan MGP et la paroi latérale du creuset en quartz (10) et d'un faible champ magnétique de 1500 à 3000 Gauss en dessous d'une interface solide-liquide.

6. Procédé de fabrication d'un lingot monocristallin semi-conducteur selon la revendication 5,
dans lequel le procédé comprend en outre la fourniture d'un moyen de protection contre la chaleur (70) autour d'un monocristal semi-conducteur en croissance pour bloquer la chaleur émise par une partie de bord de l'interface solide-liquide, et la maîtrise d'un espace entre le moyen de protection contre la chaleur (70) et le bain de fusion de semi-conducteur (M) pour maîtriser un gradient de température de la partie de bord de l'interface solide-liquide.

7. Procédé de fabrication d'un lingot monocristallin semi-conducteur selon la revendication 6,
dans lequel le gradient de température de la partie de bord de l'interface solide-liquide est maîtrisé pour être au même niveau que celui d'une partie centrale de l'interface solide-liquide.

8. Procédé de fabrication d'un lingot monocristallin selon la revendication 5,
dans lequel le champ magnétique horizontal est formé en disposant une paire de bobines à des côtés opposés autour du creuset en quartz (10), et
dans lequel le champ magnétique horizontal est formé en commandant la dimension, la position ou la forme de chaque bobine de la paire de bobines, ou la direction et l'intensité du courant appliqué à la bobine.
